(19) Europäisches Patentamt
European Patent Office
Office européen des brevets

(11) **EP 4 431 988 A1**

(12) **EUROPEAN PATENT APPLICATION**

(43) Date of publication:
**18.09.2024 Bulletin 2024/38**

(21) Application number: **23161366.2**

(22) Date of filing: **13.03.2023**

(51) International Patent Classification (IPC):
**G02B 5/18** (2006.01)     **G02B 26/08** (2006.01)

(52) Cooperative Patent Classification (CPC):
**G02B 5/1828; G02B 21/0016; G02B 21/10;
G02B 21/18; G02B 21/367; G02B 26/0808;
G02B 27/283; G03F 7/706847; G03F 7/706849;
G03F 9/7065**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **ASML Netherlands B.V.
5500 AH Veldhoven (NL)**

(72) Inventors:
• **VAN VOORST, Peter Danny
5500 AH Veldhoven (NL)**
• **VAN GREEVENBROEK, Hendrikus Robertus
Marie
5500 AH Veldhoven (NL)**

(74) Representative: **ASML Netherlands B.V.
Corporate Intellectual Property
P.O. Box 324
5500 AH Veldhoven (NL)**

(54) **AN ILLUMINATION MODULE FOR A METROLOGY DEVICE**

(57) Disclosed is an illumination configuration module comprising: an active area comprising alternating first reflective regions (1010, 1010') and second reflective regions (1020, 1020'), said first reflective regions (1010, 1010') and second reflective regions (1020, 1020') comprising a configurable displacement between them, in a direction perpendicular to said active area, so as to selectively form a diffractive grating structure for selectively diffracting dispersed radiation incident on said active area; wherein a local pitch (P1, P2) of said active area, the local pitch (P1, P2) being defined by a combined width of one of said first reflective regions (1010, 1010') and an adjacent one of said second reflective regions (1020, 1020'), varies within said active area.

EP 4 431 988 A1

(b)

**Fig. 10**

## Description

FIELD

The present invention relates to an illumination configuration module for configuring a beam of illumination, and in particular such an illumination configuration module in relation to metrology applications in the manufacture of integrated circuits.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, having a wavelength within the range 4-20 nm, for example 6.7 nm or 13.5 nm, may be used to form smaller features on a substrate than a lithographic apparatus which uses, for example, radiation with a wavelength of 193 nm.

Low-k1 lithography may be used to process features with dimensions smaller than the classical resolution limit of a lithographic apparatus. In such process, the resolution formula may be expressed as $CD = k_1 \times \lambda / NA$, where $\lambda$ is the wavelength of radiation employed, NA is the numerical aperture of the projection optics in the lithographic apparatus, CD is the "critical dimension" (generally the smallest feature size printed, but in this case half-pitch) and k1 is an empirical resolution factor. In general, the smaller k1 the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

Metrology tools are used in many aspects of the IC manufacturing process, for example as alignment tools for proper positioning of a substrate prior to an exposure, leveling tools to measure a surface topology of the substrate, for e.g., focus control and scatterometry based tools for inspecting/measuring the exposed and/or etched product in process control. In each case, a radiation source is required. For various reasons, including measurement robustness and accuracy, broadband or white light radiation sources are increasingly used for such metrology applications. In many cases, not all the spectral and/or polarization components of the white light are used for a particular measurement. For example, it is often desirable to vary the spectral and/or polarization characteristics of the radiation for a particular measurement. This can be achieved by filtering and polarization switching. This, however, comes with a system throughput penalty, as switching the radiation properties using present methods incurs a significant switching time penalty.

It is desirable to improve the configurability of measurement radiation characteristics.

SUMMARY

According to a first aspect of the invention, there is provided a radiation modulation device comprising: an active area comprising alternating first reflective regions and second reflective regions, said first reflective regions and second reflective regions comprising a configurable displacement between them, in a direction perpendicular to said active area, so as to selectively form a diffractive grating structure for selectively diffracting dispersed radiation incident on said active area; wherein a local pitch of said active area, the local pitch being defined by a combined width of one of said first reflective regions and an adjacent one of said second reflective regions, varies within said active area.

According to a second aspect of the invention, there is provided a radiation modulation device comprising: an active area comprising alternating first reflective regions and second reflective regions, said first reflective regions and second reflective regions comprising a configurable displacement between them, in a direction perpendicular to said active area, so as to selectively form a diffractive grating structure for selectively diffracting dispersed radiation incident on said active area; wherein the active area comprises an adapted reflectivity ratio, describing a reflectivity of the first reflective regions with respect to a reflectivity of second reflective regions, the adapted reflectivity ratio minimizing a difference in reflectivity between the first reflective regions and the second reflective regions.

Other aspects of the invention comprise metrology device comprising an illumination arrangement according the first aspect, second aspect or third aspect.

BRIEF DESCRIPTION OF THE DRAWINGS

Embodiments of the invention will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 depicts a schematic overview of a scatterometry apparatus used as a metrology device, which may comprise a radiation source according to embodiments of the invention;
- Figures 5(a), 5(b), 5(c) and 5(d) comprise (a) a schematic diagram of a dark field scatterometer for use in measuring targets according to embodiments of the invention using a first pair of illumination apertures, (b) a detail of diffraction spectrum of a target grating for a given direction of illumination (c) a second pair of illumination apertures providing further illumination modes in using the scatterometer for diffraction based overlay measurements and (d) a third pair of illumination apertures combining the first and second pair of apertures;
- Figure 6 depicts a schematic overview of a level sensor apparatus which may comprise a radiation source according to embodiments of the invention;
- Figure 7 depicts a schematic overview of an alignment sensor apparatus which may comprise a radiation source according to embodiments of the invention;
- Figures 8(a), 8(b) and 8(c) depict schematically a grating light valve (GLV), illustrating its basic operation in (a) a top view, (b) a cross-sectional view in a first configuration and (c) a cross-sectional view in a second configuration;
- Figures 9(a) and 9(b) depict schematically, respectively a first view (along the Y-axis) and second view (along the X-axis) of a GLV based illumination configuration module;
- Figure 10(a) depicts schematically portions of a GLV active area in cross-section, illustrating the problem with using a GLV device in a first order mode; and Figure 10(b) depicts schematically portions of a GLV active area in cross-section according to an embodiment;
- Figure 11 depicts schematically a view along the Y-axis of a GLV based illumination configuration module according to a first embodiment;
- Figure 12 depicts schematically a view along the Y-axis of a GLV based illumination configuration module according to a second embodiment;
- Figure 13 depicts schematically a top view of a GLV based illumination configuration module according to a third embodiment;
- Figure 14 depicts schematically a top view of a GLV based illumination configuration module according to a fourth embodiment; and
- Figure 15 depicts schematically in cross-section the problem of edge diffraction in a GLV device.

DETAILED DESCRIPTION

In the present document, the terms "radiation" and "beam" are used to encompass all types of electromagnetic radiation, including one, some or all of: visible (e.g., 400nm-700nm) (near-) infrared radiation (700nm to 1000nm) ultraviolet radiation (e.g. with a wavelength of 365, 248, 193, 157 or 126 nm) and EUV (extreme ultraviolet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

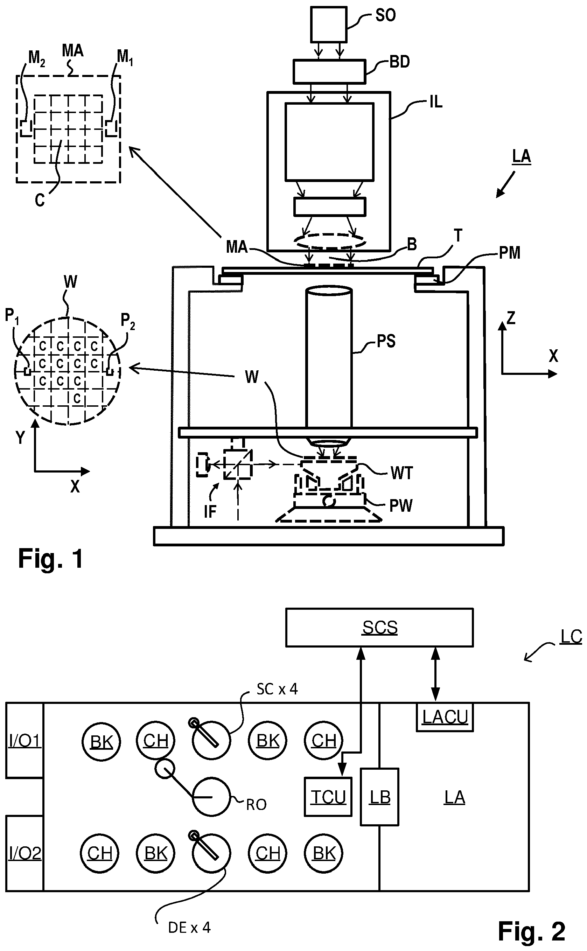

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre- and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, are typically under the control of a track control unit TCU that in itself may be controlled by a supervisory control system SCS, which may also control the lithographic apparatus LA, e.g. via lithography control unit LACU.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), etc. For this purpose, inspection tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semi-latent image (image in a resist layer after a post-exposure bake step PEB), or on a developed resist image (in which the exposed or unexposed parts of the resist have been removed), or even on an etched image (after a pattern transfer step such as etching).

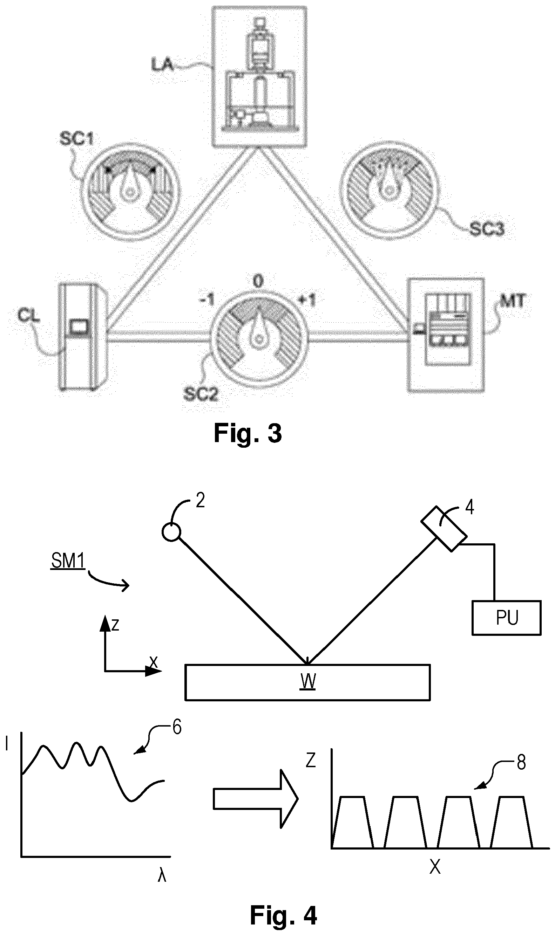

Typically the patterning process in a lithographic apparatus LA is one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - typically within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). Typically, the resolution enhancement techniques are arranged to match the patterning possibilities of the lithographic apparatus LA. The computer system CL may also be used to detect where within the process window the lithographic apparatus LA is currently operating (e.g. using input from the metrology tool MT) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g., for process control and verification. Tools to make such measurement are typically called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from soft x-ray and visible to near-IR wavelength range.

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (typically overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. Typically the pitch and line-width of the structures in the gratings strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resembles the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

A metrology apparatus, such as a scatterometer, is depicted in Figure 4. It comprises a broadband (white light) radiation projector 2 which projects radiation onto a substrate 6. The reflected or scattered radiation is passed to a spectrometer detector 4, which measures a spectrum 10 (i.e. a measurement of intensity as a function of wavelength) of the specular reflected radiation. From this data, the structure or profile giving rise to the detected spectrum may be reconstructed by processing unit PU, e.g. by Rigorous Coupled Wave Analysis and non-linear regression or by comparison with a library of simulated spectra as shown at the bottom of Figure 3. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

Overall measurement quality of a lithographic parameter via measurement of a metrology target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016/0161863 and published US patent application US 2016/0370717A1, incorporated herein by reference in its entirety.

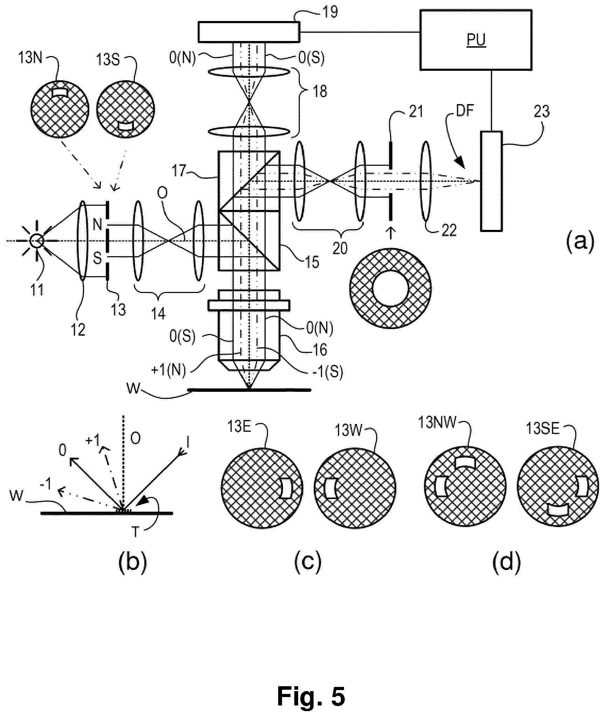

Figure 5(a) presents an embodiment of a metrology apparatus and, more specifically, a dark field scatterometer. A target T and diffracted rays of measurement radiation used to illuminate the target are illustrated in more detail in Figure 5(b). The metrology apparatus illustrated is of a type known as a dark field metrology apparatus. The metrology apparatus may be a standalone device or incorporated in either the lithographic apparatus LA, e.g., at the measurement station, or the lithographic cell LC. An optical axis, which has several branches throughout the apparatus, is represented by a dotted line O. In this apparatus, light emitted by source 11 (e.g., a xenon lamp) is directed onto substrate W via a beam splitter 15 by an optical system comprising lenses 12, 14 and objective lens 16. These lenses are arranged in a double sequence of a 4F arrangement. A different lens arrangement can be used, provided that it still provides a substrate image onto a detector, and simultaneously allows for access of an intermediate pupil-plane for spatial-frequency filtering. Therefore, the angular range at which the radiation is incident on the substrate can be selected by defining a spatial intensity distribution in a plane that presents the spatial spectrum of the substrate plane, here referred to as a (conjugate) pupil plane. In particular, this can be done by inserting an aperture plate 13 of suitable form between lenses 12 and 14, in a plane which is a back-projected image of the objective lens pupil plane. In the example illustrated, aperture plate 13 has different forms, labeled 13N and 13S, allowing different illumination modes to be selected. The illumination system in the present examples forms an off-axis illumination mode. In the first illumination mode, aperture plate 13N provides off-axis from a direction designated, for the sake of description only, as 'north'. In a second illumination mode, aperture plate 13S is used to provide similar illumination, but from an opposite direction, labeled 'south'. Other modes of illumination are possible by using different apertures. The rest of the pupil plane is desirably dark as any unnecessary light outside the desired illumination mode will interfere with the desired measurement signals.

As shown in Figure 5(b), target T is placed with substrate W normal to the optical axis O of objective lens 16. The substrate W may be supported by a support (not shown). A ray of measurement radiation I impinging on target T from an angle off the axis O gives rise to a zeroth order ray (solid line 0) and two first order rays (dot-chain line +1 and double dot-chain line -1). It should be remembered that with an overfilled small target, these rays are just one of many parallel rays covering the area of the substrate including metrology target T and other features. Since the aperture in plate 13 has a finite width (necessary to admit a useful quantity of light, the incident rays I will in fact occupy a range of angles, and the diffracted rays 0 and +1/-1 will be spread out somewhat. According to the point spread function of a small target, each order +1 and -1 will be further spread over a range of angles, not a single ideal ray as shown. Note that the grating pitches of the targets and the illumination angles can be designed or adjusted so that the first order rays entering the objective lens are closely aligned with the central optical axis. The rays illustrated in Figure 5(a) and 3(b) are shown somewhat off axis, purely to enable them to be more easily distinguished in the diagram.

At least the 0 and +1 orders diffracted by the target T on substrate W are collected by objective lens 16 and directed back through beam splitter 15. Returning to Figure 5(a), both the first and second illumination modes are illustrated, by designating diametrically opposite apertures labeled as north (N) and south (S). When the incident ray I of measurement radiation is from the north side of the optical axis, that is when the first illumination mode is applied using aperture plate 13N, the +1 diffracted rays, which are labeled +1(N), enter the objective lens 16. In contrast, when the second illumination mode is applied using aperture plate 13S the -1 diffracted rays (labeled 1(S)) are the ones which enter the lens 16.

A second beam splitter 17 divides the diffracted beams into two measurement branches. In a first measurement branch, optical system 18 forms a diffraction spectrum (pupil plane image) of the target on first sensor 19 (e.g. a CCD or CMOS sensor) using the zeroth and first order diffractive beams. Each diffraction order hits a different point on the sensor, so that image processing can compare and contrast orders. The pupil plane image captured by sensor 19 can be used for focusing the metrology apparatus and/or normalizing intensity measurements of the first order beam. The pupil plane image can also be used for many measurement purposes such as reconstruction.

In the second measurement branch, optical system 20, 22 forms an image of the target T on sensor 23 (e.g. a CCD or CMOS sensor). In the second measurement branch, an aperture stop 21 is provided in a plane that is conjugate to the pupil-plane. Aperture stop 21 functions to block the zeroth order diffracted beam so that the image of the target formed on sensor 23 is formed only from the -1 or +1 first order beam. The images captured by sensors 19 and 23 are output to processor PU which processes the image, the function of which will depend on the particular type of measurements being performed. Note that the term 'image' is used here in a broad sense. An image of the grating lines as such will not be formed, if only one of the -1 and +1 orders is present.

The particular forms of aperture plate 13 and field stop 21 shown in Figure 5 are purely examples. In another embodiment of the invention, on-axis illumination of the targets is used and an aperture stop with an off-axis aperture is used to pass substantially only one first order of diffracted light to the sensor. In yet other embodiments, 2nd, 3rd and higher order beams (not shown in Figure 5) can be used in measurements, instead of or in addition to the first order beams.

In order to make the measurement radiation adaptable to these different types of measurement, the aperture plate 13 may comprise a number of aperture patterns formed around a disc, which rotates to bring a desired pattern into place. Note that aperture plate 13N or 13S can only be used to measure gratings oriented in one direction (X or Y depending on the set-up). For measurement of an orthogonal grating, rotation of the target through 90° and 270° might be implemented. Different aperture plates are shown in Figures 5(c) and (d). The use of these, and numerous other variations and applications of the apparatus are described in prior published applications, mentioned above.

Another type of metrology tool used in IC manufacture is a topography measurement system, level sensor or height sensor. Such a tool may be integrated in the lithographic apparatus, for measuring a topography of a top surface of a substrate (or wafer). A map of the topography of the substrate, also referred to as height map, may be generated from these measurements indicating a height of the substrate as a function of the position on the substrate. This height map may subsequently be used to correct the position of the substrate during transfer of the pattern on the substrate, in order to provide an aerial image of the patterning device in a properly focus position on the substrate. It will be understood that "height" in this context refers to a dimension broadly out of the plane to the substrate (also referred to as Z-axis). Typically, the level or height sensor performs measurements at a fixed location (relative to its own optical system) and a relative movement between the substrate and the optical system of the level or height sensor results in height measurements at locations across the substrate.

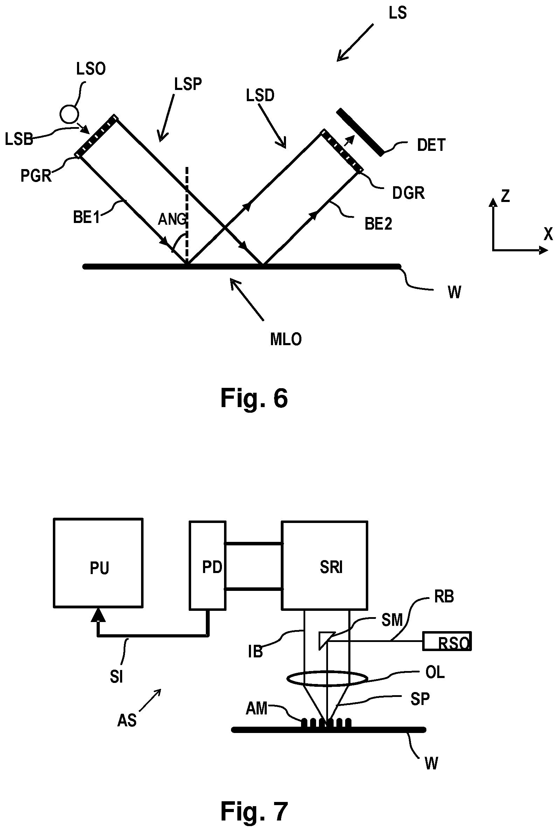

An example of a level or height sensor LS as known in the art is schematically shown in Figure 6, which illustrates only the principles of operation. In this example, the level sensor comprises an optical system, which includes a projection unit LSP and a detection unit LSD. The projection unit LSP comprises a radiation source LSO providing a beam of radiation LSB which is imparted by a projection grating PGR of the projection unit LSP. The radiation source LSO may be, for example, a narrowband or broadband light source, such as a supercontinuum light source, polarized or non-polarized, pulsed or continuous, such as a polarized or non-polarized laser beam. The radiation source LSO may include a plurality of radiation sources having different colors, or wavelength ranges, such as a plurality of LEDs. The radiation source LSO of the level sensor LS is not restricted to visible radiation, but may additionally or alternatively encompass UV and/or IR radiation and any range of wavelengths suitable to reflect from a surface of a substrate.

The projection grating PGR is a periodic grating comprising a periodic structure resulting in a beam of radiation BE1 having a periodically varying intensity. The beam of radiation BE1 with the periodically varying intensity is directed towards a measurement location MLO on a substrate W having an angle of incidence ANG with respect to an axis perpendicular (Z-axis) to the incident substrate surface between 0 degrees and 90 degrees, typically between 70 degrees and 80 degrees. At the measurement location MLO, the patterned beam of radiation BE1 is reflected by the substrate W (indicated by arrows BE2) and directed towards the detection unit LSD.

In order to determine the height level at the measurement location MLO, the level sensor further comprises a detection system comprising a detection grating DGR, a detector DET and a processing unit (not shown) for processing an output signal of the detector DET. The detection grating DGR may be identical to the projection grating PGR. The detector DET produces a detector output signal indicative of the light received, for example indicative of the intensity of the light received, such as a photodetector, or representative of a spatial distribution of the intensity received, such as a camera. The detector DET may comprise any combination of one or more detector types.

By means of triangulation techniques, the height level at the measurement location MLO can be determined. The detected height level is typically related to the signal strength as measured by the detector DET, the signal strength having a periodicity that depends, amongst others, on the design of the projection grating PGR and the (oblique) angle of incidence ANG.

The projection unit LSP and/or the detection unit LSD may include further optical elements, such as lenses and/or mirrors, along the path of the patterned beam of radiation between the projection grating PGR and the detection grating DGR (not shown).

In an embodiment, the detection grating DGR may be omitted, and the detector DET may be placed at the position where the detection grating DGR is located. Such a configuration provides a more direct detection of the image of the projection grating PGR.

In order to cover the surface of the substrate W effectively, a level sensor LS may be configured to project an array of measurement beams BE1 onto the surface of the substrate W, thereby generating an array of measurement areas MLO or spots covering a larger measurement range.

Various height sensors of a general type are disclosed for example in US7265364 and US7646471, both incorporated by reference. A height sensor using UV radiation instead of visible or infrared radiation is disclosed in US2010233600A1, incorporated by reference. In WO2016102127A1, incorporated by reference, a compact height sensor is described which uses a multi-element detector to detect and recognize the position of a grating image, without needing a detection grating.

Another type of metrology tool used in IC manufacture is an alignment sensor. A critical aspect of performance of the lithographic apparatus is therefore the ability to place the applied pattern correctly and accurately in relation to features laid down in previous layers (by the same apparatus or a different lithographic apparatus). For this purpose, the substrate is provided with one or more sets of marks or targets. Each mark is a structure whose position can be measured at a later time using a position sensor, typically an optical position sensor. The position sensor may be referred to as "alignment sensor" and marks may be referred to as "alignment marks".

A lithographic apparatus may include one or more (e.g. a plurality of) alignment sensors by which positions of alignment marks provided on a substrate can be measured accurately. Alignment (or position) sensors may use optical phenomena such as diffraction and interference to obtain position information from alignment marks formed on the substrate. An example of an alignment sensor used in current lithographic apparatus is based on a self-referencing interferometer as described in US6961116. Various enhancements and modifications of the position sensor have been developed, for example as disclosed in US2015261097A1. The contents of all of these publications are incorporated herein by reference.

Figure 7 is a schematic block diagram of an embodiment of a known alignment sensor AS, such as is described, for example, in US6961116, and which is incorporated by reference. Radiation source RSO provides a beam RB of radiation of one or more wavelengths, which is diverted by diverting optics onto a mark, such as mark AM located on substrate W, as an illumination spot SP. In this example the diverting optics comprises a spot mirror SM and an objective lens OL. The illumination spot SP, by which the mark AM is illuminated, may be slightly smaller in diameter than the width of the mark itself.

Radiation diffracted by the alignment mark AM is collimated (in this example via the objective lens OL) into an information-carrying beam IB. The term "diffracted" is intended to include zero-order diffraction from the mark (which may be referred to as reflection). A self-referencing interferometer SRI, e.g. of the type disclosed in US6961116 mentioned above, interferes the beam IB with itself after which the beam is received by a photodetector PD. Additional optics (not shown) may be included to provide separate beams in case more than one wavelength is created by the radiation source RSO. The photodetector may be a single element, or it may comprise a number of pixels, if desired. The photodetector may comprise a sensor array.

The diverting optics, which in this example comprises the spot mirror SM, may also serve to block zero order radiation reflected from the mark, so that the information-carrying beam IB comprises only higher order diffracted radiation from the mark AM (this is not essential to the measurement, but improves signal to noise ratios).

Intensity signals SI are supplied to a processing unit PU. By a combination of optical processing in the block SRI and computational processing in the unit PU, values for X- and Y-position on the substrate relative to a reference frame are output.

A single measurement of the type illustrated only fixes the position of the mark within a certain range corresponding to one pitch of the mark. Coarser measurement techniques are used in conjunction with this to identify which period of a sine wave is the one containing the marked position. The same process at coarser and/or finer levels may be repeated at different wavelengths for increased accuracy and/or for robust detection of the mark irrespective of the materials from which the mark is made, and materials on and/or below which the mark is provided. The wavelengths may be multiplexed and demultiplexed optically so as to be processed simultaneously, and/or they may be multiplexed by time division or frequency division.

In this example, the alignment sensor and spot SP remain stationary, while it is the substrate W that moves. The alignment sensor can thus be mounted rigidly and accurately to a reference frame, while effectively scanning the mark AM in a direction opposite to the direction of movement of substrate W. The substrate W is controlled in this movement by its mounting on a substrate support and a substrate positioning system controlling the movement of the substrate support. A substrate support position sensor (e.g. an interferometer) measures the position of the substrate support (not shown). In an embodiment, one or more (alignment) marks are provided on the substrate support. A measurement of the position of the marks provided on the substrate support allows the position of the substrate support as determined by the position sensor to be calibrated (e.g. relative to a frame to which the alignment system is connected). A measurement of the position of the alignment marks provided on the substrate allows the position of the substrate relative to the substrate support to be determined.

Metrology tools MT, such as a scatterometer, topography measurement system, or position measurement system mentioned above may use radiation originating from a radiation source to perform a measurement. The properties of the radiation used by a metrology tool may affect the type and quality of measurements that may be performed. For some applications, it may be advantageous to use multiple radiation frequencies and/or polarization states to measure a substrate, for example broadband radiation may be used. Multiple different frequencies may be able to propagate, irradiate, and scatter off a metrology target with no or minimal interference with other frequencies. Therefore different frequencies may for example be used to obtain more metrology data simultaneously. Different radiation frequencies may also be able to interrogate and discover different properties of a metrology target. Broadband radiation may be useful in metrology systems MT such as for example level sensors, alignment mark measurement systems, scatterometry tools, or inspection tools. A broadband radiation source may be a supercontinuum source.

.In many metrology applications, such as scatterometry or interferometry based metrology applications, e.g., for performance of pre-exposure metrology (such as alignment) or post-exposure metrology (e.g., overlay, CD, focus or other parameter of interest metrology), different information can be obtained from measurement of the same structure depending on the wavelength and polarization state of the measurement illumination used. For example, some present metrology systems provide measurement illumination configurable over multiple colors and three polarization settings (Horizontal, Vertical and both). However, the presently used illumination configuration modules (color switching modules) in such systems tend to be based on bulky mechanical modules which are slow. Additionally, such modules provide only three options when selecting the polarization of the incident beam: all wavelengths at a first polarization state (e.g., horizontal H), all wavelengths at a second polarization state (e.g., vertical V) or all wavelengths at both of these polarizations. It is very possible that any one polarization choice is suboptimal at some wavelengths. To measure each wavelength at its optimum polarization would require twice as many measurements as a single polarization measurement, with a slow polarization switch halfway through. Furthermore, arbitrary combinations of different polarization states are simply not presently possible.

A fast illumination configuration module or color switching module has been described, based on the grating light valve (GLV) concept. A GLV device disperses light (having been dispersed onto the GLV) such that the module can selectively remove or modulate light at one or more specific wavelengths. The resulting spectrum can be configured to comprise any desired shape, and can be varied at very high frequencies, possibly up to the MHz range. Such engineered spectra are a fast (microsecond switchable) way to extract a large amount of information from a target. However the known literature on GLV based illumination configuration describes only color selection, without any polarization selection functionality. Wavelength is only one degree of freedom. Polarization of the measurement illumination is another useful degree of freedom which may be exploited in metrology.

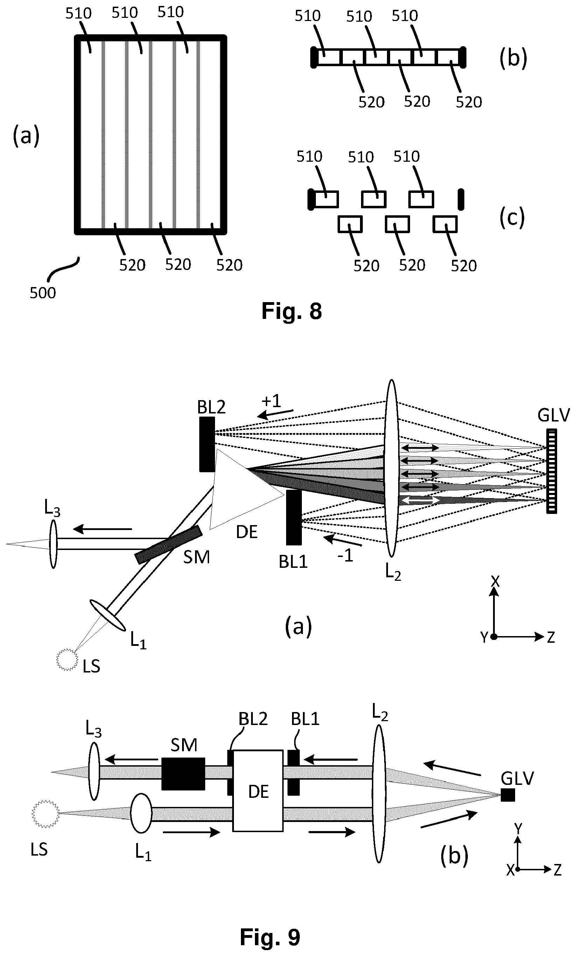

By way of example, and with reference to Figures 8 and 9, a GLV based illumination configuration module will now be described, configured to selectively transmit or block (diffract or reflect) at least part of incident broadband illumination. A GLV is an electrically-programmable diffraction grating based on Micro-Electro-Mechanical Systems (MEMS) technology. The GLV device may comprise configurable diffractive structures for selectively reflecting or diffracting the incident broadband illumination into an output radiation beam. Accordingly, output radiation illumination from such a module may comprise a spectrally configured beam having been modulated by the GLV device. A GLV device as used in embodiments disclosed herein may be a GLV device marketed by Silicon Light Machines (SLM), and/or based on GLV concept described in US6947613B, which is incorporated herein by reference.

Figures 8(a)-8(c) illustrate the working principal behind the GLV. Figures 8(a)-8(c) are schematic illustrations of a GLV pixel or component 500 from above and end-on, respectively. Please note that the GLV component shown in Figures 8(a)-8(c) is only an example design, other different GLV designs (e.g., the "true-GLV" design used in the G1088 and G8192 modules marketed by SLM) can also be used in any of the illumination configuration modules disclosed herein. In a true-GLV design, the bias ribbons are replaced by metallized regions on a substrate (bottom of the GLV device).

The GLV component comprises alternating GLV reflective ribbons of two types: static or bias ribbons 510 (more generally bias regions) which are typically grounded along with a common electrode, and driven or active ribbons 520 (more generally active regions) which are driven by an electronic driver channel. A GLV device may comprise an active area comprising or defined by a plurality of alternating first reflective regions (e.g., first reflective ribbons or bias ribbons) and second reflective regions (e.g., second reflective ribbons or active ribbons). The active area may comprise a plurality of GLV components 500 arranged in an array (e.g., a 1D or 2D array), or else a single array of alternating first reflective regions and second reflective regions.

The active and bias ribbons may be essentially identical other than in how they are driven. In an embodiment, when no voltage is applied to the active ribbons 520, they are co-planar with the bias ribbons, a configuration illustrated in Figure 8(b). In this configuration, the GLV acts essentially as a mirror, with incident light being specularly reflected (i.e., forming specularly reflected radiation or zeroth diffraction order radiation). When a voltage is applied to the active ribbons 520, as illustrated in Figure 8(c), they deflect relative to the bias ribbons 510, establishing a square-well diffraction grating. In this state, incident light is diffracted into fixed diffraction angles. The ratio of light reflected with respect to light diffracted can be continuously varied by controlling the voltage on the active ribbons 520, which controls the magnitude of their deflection. As such, the amount of light diffracted by the GLV can be controlled in an analog fashion from zero (full specular reflection) to all incident light (zero specular reflection). This control of the amount of reflected radiation with respect to the amount of radiation diffracted into nonzero diffraction orders may be referred to as modulating the illumination within the context of this disclosure.

Figures 9(a) and 9(b) schematically illustrate a known illumination configuration module from two different viewpoints. A broadband input beam emitted from a broadband light source LS is dispersed in the X direction by a beam dispersion element DE, which may comprise, for example, a prism or a grating. The dispersion of the broadband input beam is achieved based on the principle that the direction of the light emerging from the beam dispersion element DE is wavelength dependent. The broadband input beam may be optionally collimated by a first optical lens $L_1$ before being dispersed by the beam dispersion element DE. The dispersed broadband input beam may then be focused (e.g., by a second optical lens $L_2$) onto the ribbons of the GLV device which is located substantially at the focal plane of the second lens $L_2$. The different shading is indicative of different wavelengths of the dispersed radiation.

In some embodiments, the GLV device may be operated in a wavelength selection mode to completely select one or more chosen wavelengths (e.g., without significant attenuation), and completely block the non-selected wavelengths. That is to say, the ribbons of the GLV device that correspond to the selected wavelengths may be set to equal heights such that they act like a standard mirror for the selected wavelengths and the other ribbons are actuated in such a way that they form a grating diffracting the undesired wavelengths into higher diffraction orders, e.g., -1st and +1st diffraction orders. These higher diffraction orders are then blocked or dumped by the beam blocks BL1, BL2, respectively. The GLV device may be operated also in intermediate modes or spectral shaping modes, e.g., to form a grating which partially reflects and partially diffracts the incident radiation for one or more wavelengths so as to attenuate but not completely block these one or more wavelengths. The degree of attenuation may be controlled via the ribbon configuration (the offset of the active ribbons with respect to the static ribbons). In this way, the spectral shape/constitution of the output radiation can be dynamically controlled.

The spatially modulated reflected (zeroth order) radiation from the GLV device may be captured by the second optical lens $L_2$. The spatially modulated optical beam is recombined on a return path, e.g., using the same dispersion element DE as was used to disperse the beam on the outward path (alternatively separate dispersion elements can be used for dispersing and combining). The return path within the dispersion element DE may be substantially parallel with and displaced in the Y direction with respect to the outward path. The recombined output illumination beam may then be directed by the steering mirror SM towards, for example, a third optical lens $L_3$. This third optical lens $L_3$ may act as an output lens so as to focus the output illumination beam into a metrology device; e.g., via a suitable optical fiber such as a single mode photonic crystal fiber.

Figure 9 illustrates the GLV device configured in a "zeroth order mode" such that it applies a certain spatial modulation to the focused broadband input beam so as to selectively reflect desired wavelengths and diffract away undesired wavelengths. Therefore, in such a configuration the diffracted radiation is blocked/dumped and the specularly reflected (zeroth diffraction order) radiation is selected (e.g., transmitted into an output illumination beam). In Figure 9, an aperture stop may be provided in a pupil plane with the aim of maximizing transmission of the zeroth order, and maximizing blocking (minimizing transmission) of the first orders (and other diffraction orders).

This zeroth order mode of operation has the advantage of preserving etendue, as the specularly reflected radiation will have no wavelength dependent output (reflection) angle. As such, it is fairly straight-forward to combine the selected wavelengths into a common path and preserve the small etendue required to couple the light into a (e.g., single mode) fiber.

A further advantage of the arrangement illustrated in Figure 9 is that the optical path has a low number of elements due to the use of lens L2 and prism in both outward and return directions. This has a cost and volume advantage.

A significant drawback of operating the GLV device in a zeroth order mode configuration such as described is that out-of-band suppression of the GLV device is insufficient for many applications, e.g., including being used as a radiation source in metrology tools such as those illustrated in Figures 4 to 7. With such a zeroth order mode configuration, there will always be a small but significant leakage of the unwanted color(s) into the output illumination beam. For example, when configured in a zeroth order mode it is very difficult, if not impossible, to reduce leakage to significantly below 0.1% (i.e., there will typically be at least 0.1% of the incident radiation which is reflected from GLV regions configured to diffract/block all incident radiation on those regions). For metrology applications, this leakage should be at least one order of magnitude smaller than this, i.e., a suppression of at least four orders of magnitude smaller than the full signal (at least 0.01%).

Configuring the GLV ribbons to form a grating having a sufficiently high diffraction efficiency to achieve 0.01% leakage or better is difficult or impossible because there will always be gaps between the ribbons, which results in light being reflected via these gaps.

To address this limited diffraction efficiency and therefore out-of-band suppression issue, it is proposed to reverse the configuration such that the diffracted radiation (e.g., first order although other non-zero orders may be used) is used and the specular, zeroth order radiation rejected; i.e., to configure the GLV device in a "first order mode". In such a configuration, the diffraction efficiency becomes less critical; while some diffraction inefficiency may mean some (wanted) radiation loss, it does not affect out-of-bound suppression. Very little or no radiation incident on a GLV region configured to reflect away radiation will be diffracted in the same direction(s) as the wanted first order(s), so out-of-bound suppression will be very good.

The drawback of using a first order mode of operation is that etendue is no longer preserved. The outgoing radiation will now (per first order) comprise a wavelength dependent diffraction angle (output radiation direction). Therefore to properly overlap all the wavelengths in a single common path using a conventional GLV device in a first order mode, for only one of the diffraction orders (there will of course be two complementary first orders, conventionally described as a +1 order and -1 order), an optical solution is required such as the provision of a dispersive element (e.g. a prism or grating) before and after a collimating lens. Such a large number of additional optical elements is undesirable in terms of cost and volume. Even with the additional optics, the recombination of the different wavelengths will not be as good as for the zeroth order configuration, making it hard to couple the light back into a (single mode) fiber. As such, while the out-of-band suppression requirement can be met with a first-order selection scheme, it will be difficult to collect the light diffracted light and couple it into a fiber for use in e.g., metrology.

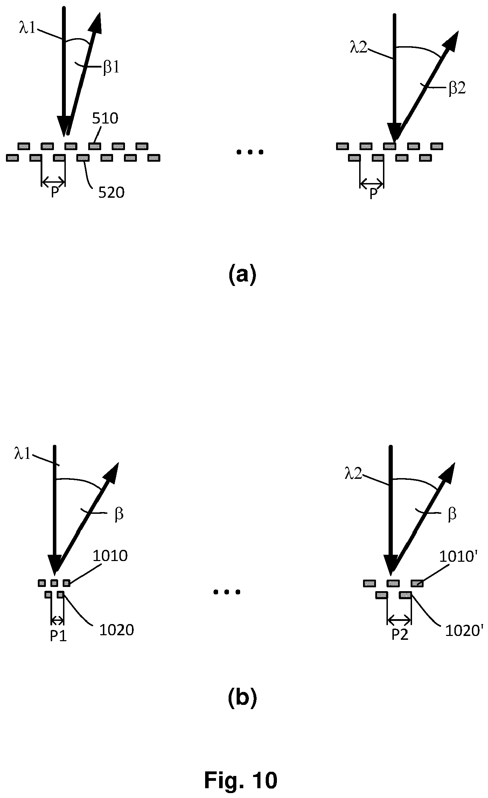

To address this issue of it being difficult to collect the first order radiation (or at least half of it) into a small etendue, it is further proposed to introduce a variable pitch or period (e.g., chirp) into the GLV device. Figure 10 illustrates this principle. Figure 10(a) graphically shows two portions of an active area of a conventional GLV device, which illustrates the problem of using a conventional GLV device in a first order mode. The active area of the conventional GLV device has a fixed pitch P, e.g., where active area (and therefore GLV grating) pitch (or local pitch) may be defined herein as the combined width, in the grating direction (X direction as shown), of two adjacent reflective regions or ribbons; e.g., a first reflective region or bias ribbon 510 and adjacent second reflective region or active ribbon 520. First incident radiation of a first wavelength $\lambda 1$ is incident on a first portion of the GLV device and is diffracted at a first diffraction angle $\beta 1$ and second incident radiation of a second wavelength $\lambda 2$ is incident on a second portion of the GLV device and is diffracted at a second diffraction angle $\beta 2$. As such the diffracted radiation is diffracted in various different directions depending on wavelength.

In Figure 10(b), again incident radiation of a first wavelength $\lambda 1$ is incident on a first portion of an active area of the GLV device and second incident radiation of a second wavelength $\lambda 2$ is incident on a second portion of the active area of the GLV device. However the first portion of the active area, comprising first reflective regions/bias ribbons 1010 and second reflective regions/active ribbons 1020, has a first local pitch P1 and the second portion of the active area, comprising first reflective regions/bias ribbons 1010' and second reflective regions/active ribbons 1020', has a second local pitch P2. Pitches P1 and P2 are such that the diffraction angle $\beta$ for the first wavelength $\lambda 1$ and the second wavelength $\lambda 2$ is the same. For example, where first wavelength $\lambda 1$ is half that of second wavelength $\lambda 2$, then the pitch P1 may be half that of pitch P2.

Proper local matching of the GLV device's pitch/pitch to the local wavelength can achieved for all wavelengths to ensure a substantially consistent or constant diffraction angle for all wavelengths of interest. For example, within the active area, the local pitch may be substantially locally dependent on an expected received location of each respective local wavelength of the spectrally dispersed broadband radiation (i.e., expected received locations comprise the respective locations at which each color of the dispersed radiation is expected to be received in operation). As such, a first expected received location may be arranged to receive radiation of a first wavelength and therefore the local pitch at this first expected received location may be configured for this first wavelength and a second expected received location may be arranged to receive radiation of a second wavelength and therefore the local pitch at this second expected received location may be configured for this second wavelength, such that the diffracted radiation per order is the same for each of these first and second wavelengths.

For example, the GLV device may have a pitch which decreases continuously (or more generally, varies monotonically) along its length, in correspondence with the incident wavelength onto the GLV. For example, in such an embodiment, no two pairs of a bias ribbon and adjacent active ribbon will have the same combined width, rather the pitch decreases (in the grating direction) with each successive said pair of ribbons. Alternatively, where the GLV device comprises an (e.g., 1D) array of pixels or GLV components, the pitch may decrease or vary monotonically (in the grating direction) with each successive pixel/GLV component. Other, less continuous pitch variation is possible, although with etendue preservation being correspondingly reduced.

In this manner, all wavelengths per diffraction order will propagate in (at least substantially) the same direction after the GLV device, and can be collected using a single collimating lens and prism (per diffraction order) so as to create a common path that allows for efficient outcoupling.

As such, the two limiting factors of the prior art arrangements are both mitigated: while the aforementioned gaps between ribbons will introduce some diffraction in mirror mode (rejection mode), the pitch of the diffraction grating caused by such gaps will be twice as large as the intended grating when configured in a nonmirror mode, and therefore this unwanted diffracted radiation will not propagate in the same direction as any wanted diffraction orders and will not be collected by the collection optics. Also the imperfect diffraction due to the local bending of the flexible ribbons will not limit the out-of-band suppression. It will only introduce a small (< 1% typically) loss for the selected wavelength.

As such, disclosed herein is a radiation modulation device (e.g., a GLV device) comprising: an active area comprising alternating first reflective regions (e.g., a first set of ribbons) and second reflective regions (e.g., a second set of ribbons), said first reflective regions and second reflective regions comprising a configurable displacement between them, in a direction perpendicular to said active area, so as to selectively form a diffractive grating structure for selectively diffracting dispersed radiation incident on said active area; wherein a local pitch of said active area, defined by a combined width of one of said first reflective regions and an adjacent one of said second reflective regions, varies over said active area. The first reflective regions may be fixed (e.g., bias ribbons in a "classic GLV" such as illustrated in Figure 8 or bias regions in a "true-GLV" arrangement) and the second reflective regions displaceable (e.g., active ribbons) or *vice versa.* It is also possible that both first and second reflective regions are displaceable.

Also disclosed is an illumination configuration module comprising a beam dispersion element operable to receive and spectrally disperse broadband radiation to obtain spectrally dispersed broadband radiation; and said radiation modulation device being operable to receive the spectrally dispersed broadband radiation on said active area and to selectively spectrally modulate said dispersed broadband radiation; wherein a local pitch of said active area substantially depends on an a local expected wavelength of said spectrally dispersed broadband radiation incident on said active area.

The illumination configuration module may be operable to form an output beam from only diffracted radiation, having diffracted from said active area while blocking specularly reflected radiation from said active area. The illumination configuration module may form said output beam from a single diffraction order or a respective output beam from each diffraction order of a pair of complementary diffraction orders (e.g., both orders of the same order number; typically the +1 order and -1 order). The illumination configuration module may comprise combining optics (e.g., half-waveplate for one order and a polarized beamsplitter) for combining each diffraction order of a pair of complementary diffraction orders into a single said output beam. The illumination configuration module may comprise respective beam delivery arrangements being operable to overlap said pair of complementary diffraction orders at an output of the illumination configuration module.

The pitch of said active area may vary such that said diffracted radiation comprises a substantially common diffraction angle per diffraction order for all wavelengths of interest comprised within said spectrally dispersed broadband radiation.

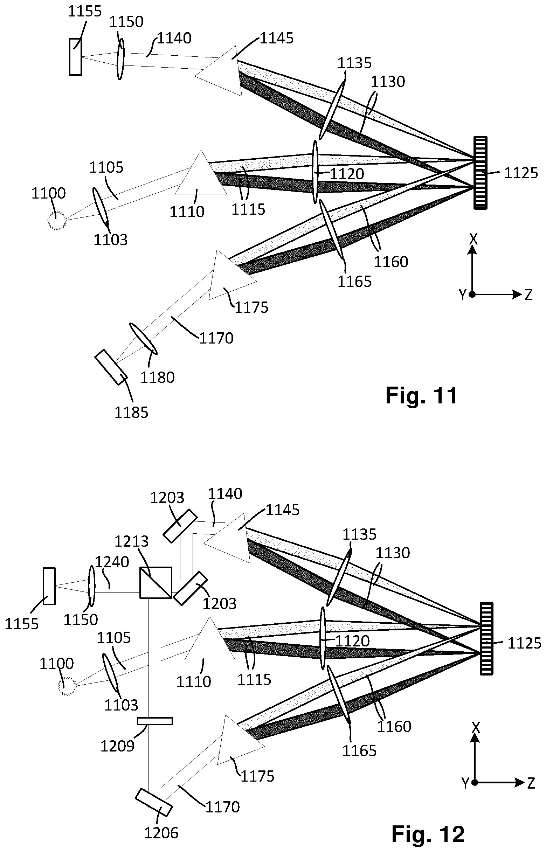

For a single metrology device, the greatest drawback in this proposed method is that the output light comprises only a single diffraction order and therefore being effectively halved. However, embodiments will be disclosed herein which address this problem. One approach is to use a single illumination configuration module to provide illumination to a pair of metrology devices (or pair of other devices), i.e., such that one metrology device receives the +1 diffracted radiation and the other metrology device receives the -1 diffracted radiation. Other embodiments may include the provision of additional optics to combine the +1 diffracted radiation and the -1 diffracted radiation for coupling into a single metrology device (or other device). If polarized radiation is assumed, the radiation can be overlapped back to an etendue equal to the entrance etendue, allowing the radiation to be coupled back into a single mode fiber. If unpolarized radiation is used, the fact that all wavelengths diffract into the same direction can be used to combine the radiation into a single multimode fiber. A number of such configurations will now be described in combination with Figures 11 to 14.

Figure 11 illustrates an embodiment where the diffracted radiation is collected into a single, small etendue, per diffraction order (or for one diffraction order). The broadband input beam (broadband radiation) 1105 emitted from a broadband light source 1100 is optionally collimated by first optical lens or input lens 1103. The (e.g., collimated) broadband input beam is then dispersed (e.g., in the X direction as shown) by beam dispersion element 1110 (e.g., a prism). The dispersed broadband radiation 1115 may then be focused (e.g., by a second optical lens 1120) onto the ribbons of the GLV device 1125 which is located substantially at the focal plane of the by a second optical lens 1120. The GLV device 1125 (in each of the embodiments illustrated in Figures 11 to 14) is as described above, e.g., comprising a variable pitch configured such that two or more wavelengths of interest incident on the GLV device 1125 are all diffracted substantially in a common direction (e.g., at a common diffraction angle) per diffraction order.

In an embodiment, the term "substantially in a common direction" may be such that the etendue of the output illumination beam (or each output illumination beam) may be no more than no more than 20%, no more than 15% greater, no more than 10% greater or no more than 5% greater than that of the broadband input beam.

For example, the etendue may have a negligible growth such that substantially all or at least most of the light can be coupled into a single mode fiber (which may comprise a Photonic Crystal Fiber (PCF), for example). Preserving the single mode, also preserves the coherence of supercontinuum source beam; this is a requirement for e.g., Digital Holographic Metrology. As such, the etendue preservation may be such that coherence is preserved and the output beam is suitable for applications relying on a coherent beam.

Etendue may be defined as the product of the area of the source and the solid angle that the system's entrance pupil subtends as seen from the source. Etendue corresponds to the beam parameter product (BPP) in Gaussian beam optics. However, the precise definition of etendue is not essential as the concepts relate to a system which does not increase etendue (or at least not by more than a small percentage), whatever its specific definition.

At least one of the first diffraction orders (e.g., +1 diffracted radiation 1130) is collected by a respective collection lens 1135 and recombined into an output illumination beam 1140 using a second beam dispersion element 1145. This output illumination beam 1140 may be focused by an output lens 1150 into (for example) a first fiber input 1155, e.g., for transporting into a first metrology device or other device. For clarity, the optical path of the blocked radiation (e.g., specularly reflected radiation from the GLV device 1125) is not shown. A (not shown) radiation dump may be used to block this radiation. In the embodiment shown, the other first diffraction order (e.g., -1 diffracted radiation 1160) is collected by a respective collection lens 1165 and recombined into an output illumination beam 1170 using a second beam dispersion element 1175. This output illumination beam 1170 may be focused by an output lens 1180 into a second fiber input 1185, e.g., for transporting into a second metrology device or other device.

As an alternative, to the arrangement shown in Figure 11, it may be that only one of the first diffraction orders 1130, 1160 is collected and used while the other of the first diffraction orders 1130, 1160 is blocked/dumped.

Figure 12 schematically shows an embodiment where the +1 diffracted radiation 1130 and the - 1 diffracted radiation 1160 are both collected and combined into a single output illumination beam 1240. Where elements are the same as Figure 11, they will not be described again. The arrangement comprises beam steering elements 1203, 1206 for, respectively, the +1 diffracted radiation 1130 and the -1 diffracted radiation 1160. The input radiation 1105 may comprise a single, linear polarization. A half-wave plate 1209 may be provided in one of the diffraction order paths (the -1 order path in the example shown, although the choice of diffraction orders is arbitrary) to rotate the polarization of that diffraction order by 90 degrees. A polarizing beam splitter 1213 can be used to combine the radiation into an (unpolarized) output illumination beam 1240. The half-wave plate and polarizing beam splitter may be substantially achromatic.

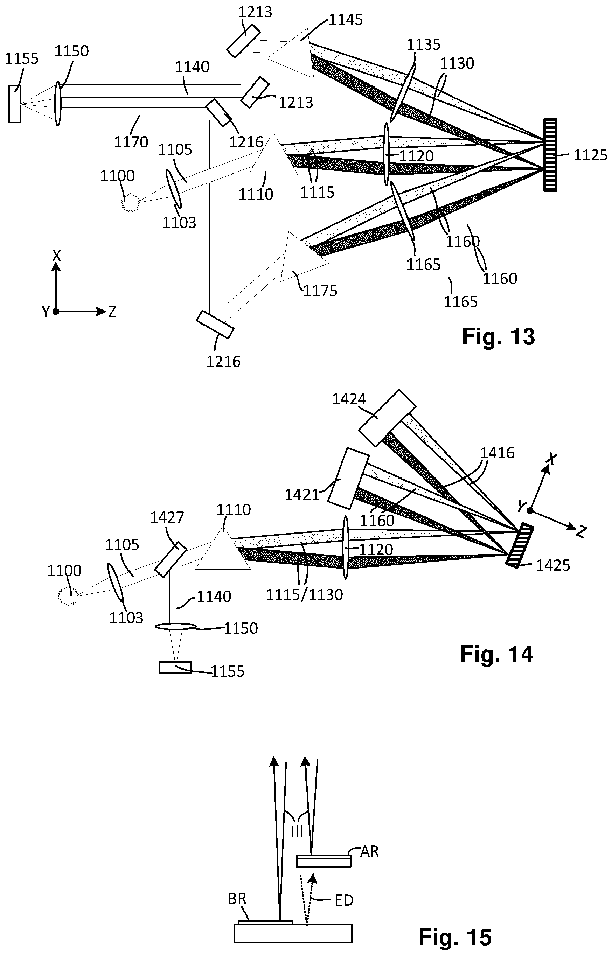

Figure 13 illustrates a similar embodiment to that of Figure 12, but where the input radiation 1105 is unpolarized (or not linearly polarized). In this embodiment, the collected orders 1140, 1170 are simply directed to the output lens 1150 and made to overlap at fiber facet or input 1155. Such an arrangement is only compatible with multimode output.

As such, even without taking advantage of a linear input polarization, it is still possible to recombine the two orders into a single, multimode output fiber. This is possible because, due to the varied ribbon pitch of the GLV device 1125, the etendue for the output is (at least substantially) the same as for the input beam. In a specific example, the largest etendue beam for the GLV device at the GLV input may be that of the 900nm beam. That has a beam waist (radius) $w_0$ = 12$\mu$m and a divergence (half angle) of $\alpha$ = 0.024 (both defined at $1/e^2$). A suitable multimode fiber has a core diameter of $d_{core}$ = 50$\mu$m and a numerical aperture $NA$ = 0.22. For the combination scheme illustrated, the spots formed by each diffraction order can be made to overlap at the fiber 1150 facet. This does not add a required size. In the far field the beams are separated. But the NA of the beam is almost 10 times larger than the divergence of the beam, so this also easily fits. Note that an oversize is required because the waist and divergence are defined at $1/e^2$. This means about 13% of the energy of the light is outside this beam definition.

Figure 14 illustrates an embodiment which, similarly to the zeroth order mode configuration in Figure 9, uses the same beam dispersing element 1110 and lens 1120 in the outward and return paths to and from the GLV device 1425. In the embodiments of Figures 10 to 13, the angle of incidence on the GLV device 1425 is maintained at zero (normal to the GLV ribbon plane). In this embodiment, it is proposed to use a non-zero angle of incidence on the GLV device 1425. Changing the angle of incidence $\alpha$, will also change the angle of diffraction $\beta$. If angle of incidence $\alpha$ = -$\beta$, the diffracted order (i.e., one first diffracted order) exactly backpropagates with respect to the incoming beam (this is a grating configuration also used in e.g., Littrow external cavity diode lasers). This condition can be met if:

$$\sin \alpha = \frac{n\lambda}{2p}$$

where $\lambda$ is the wavelength, p is the GLV (local) pitch and n is the diffraction order (i.e., n=1).

In a varied pitch GLV device 1425, the local pitch can be matched to the local wavelength of the incident radiation 1115 along the GLV grating direction to achieve this condition for all wavelengths incident on the GLV device 1425.

The backpropagation of the diffracted beam allows the use of the same optics (e.g., beam dispersion element 1110 and lens 1120 to disperse and focus the illumination on the GLV device 1425 and to collect and recombined the modulated illumination. As is similar to the Figure 9 configuration, the outgoing and return beams can be spatially separated by using lens 1120 off-center and/or tilting the GLV device 1425 around its local X-axis. Also, as before, steering mirror 1427 may be used to direct the output beam 1140 on the return path towards output lens 1150 and fiber input 1155.

The angle of incidence $\alpha$ should be kept small to avoid defocus the large field of view on the GLV. The small NA of the beams helps to accommodate a large depth of focus. Adjusting the magnification can further increase the depth of focus if needed. For example, the angle of incidence $\alpha$ may be less than 10 degrees.

The advantage of this embodiment is that the illumination paths are relatively unchanged compared to present configurations (e.g., as illustrated in Figure 9) and a less complex and more compact configuration is possible. However, it is less straightforward compared to the other embodiments to capture both diffraction orders, particularly in terms of combining them for use within a single (e.g., metrology) apparatus. In Figure 14, the other diffraction order 1160 and the zeroth order 1416 are both blocked; e.g., using respective beam dumps 1421, 1424. As an alternative, the other first order radiation 1160 may be captured into a second outward path to form a second output beam for use in a second (e.g., metrology) apparatus in a similar fashion to that illustrated in Figure 10. It may also be envisaged that a more complex optical arrangement combines the +1 and -1 diffraction orders into a single output beam or pair of overlapped beams at an output, similar to the arrangements illustrated in Figure 12 and 13 respectively.

In all the above embodiments, the GLV device may be operable in a wavelength selection mode and/or an intermediate (spectral shaping) mode, as has been described.

A further embodiment will now be described relating to the use of the GLV device in the zeroth order mode (e.g., as part of an illumination arrangement as illustrated in Figure 9. This approach is applicable to any GLV, but is more relevant to a "true-GLV". This is because the layout of a "classic GLV" is such that the effective reflectivity for the actuated and the non-actuated ribbon are identical and other leakage contributions of the classic GLV (e.g., mostly reflectivity via the gap between the ribbons) are much larger.

In such an arrangement, edge diffraction at the active ribbon will cause less energy to be reflected from the bias ribbon, or in the case of a "true-GLV", the bias regions on the bottom layer. Because of this, it is not possible to drive the GLV device to zero reflectivity in the zeroth order. This leads to a 0.2% leakage, which is too high (as has already been described). This is illustrated in Figure 15, which shows illumination III incident on and reflected from a true-GLV comprising a bias region BR and active region (or active ribbon) AR. Also shown is the edge diffracted component ED, which results in reduced energy in the reflection from the bias regions BR. Edge diffraction depends on both the wavelength and the actual distance from the ribbon to the bottom (bias regions).

To address this issue, it is proposed to adapt the effective reflectivity ratio $r_{bias}:r_{active}$ describing the reflectivity of the bias regions $r_{bias}$ with respect to the reflectivity of the active regions $r_{active}$. In particular, it is proposed to adapt this ratio to bring it closer to 1:1 (e.g., in the reflected electric field). One proposed method for achieving this is to adapt the width of the active regions with respect to the bias regions (e.g., a non-50% duty cycle); i.e., reduce the active region width to bias region width ratio. By way of a specific example the ratio (e.g., locally) of active area to half pitch may be 0.94 for a 900 nm incident wavelength. The ratio may be wavelength dependent, as will be explained below. Another proposed approach is to adapt the reflectivity of the bias region with respect to that of the active area (e.g., approximately 83% reflectivity for the bias region with respect to the active region for an incident wavelength of 900 nm).

It can be appreciated that the amount of edge diffraction depends on wavelength (the longer the wavelength, the more edge diffraction). The proposed correction can be implemented at a number of different levels:

1) Fixed adaptation across location on the GLV. This may be a compromise based on the center wavelength of the wavelength range of interest and could reduce the leakage to ~0.1% (e.g., split between largest and shortest wavelengths).

2) Gradual change of reflectivity correction across the GLV, corresponding to the expected color at a certain GLV location. This can reduce leakage to ~1e-5.

3) Exact match of correction to wavelength. It can be appreciated that, depending on wavelength, the actual distance from active ribbon to bias ribbon/bottom is not a constant factor. This will lead to a sawtooth pattern on height, and therefore also to a sawtooth profile on the correction on the GLV device.

Further embodiments are disclosed in the following list of numbered clauses:

1. A radiation modulation device comprising:

an active area comprising alternating first reflective regions and second reflective regions, said first reflective regions and second reflective regions comprising a configurable displacement between them, in a direction perpendicular to said active area, so as to selectively form a diffractive grating structure for selectively diffracting dispersed radiation incident on said active area;
wherein a local pitch of said active area, the local pitch being defined by a combined width of one of said first reflective regions and an adjacent one of said second reflective regions, varies within said active area.

2. A radiation modulation device as defined in clause 1, comprising a grating light valve device having a plurality of reflective ribbons, wherein each of said first reflective regions and second reflective regions comprises a respective reflective ribbon of said plurality of reflective ribbons.

3. A radiation modulation device as defined in clause 1 or 2, wherein said first reflective regions are fixed and only said second reflective regions are displaceable or *vice versa*.

4. A radiation modulation device as defined in any preceding clause, wherein said local pitch monotonically varies with each successive pair of a first reflective regions and adjacent second reflective region.

5. A radiation modulation device as defined in any of clauses 1 to 3, wherein said active are comprises an array of pixels, and said local pitch monotonically varies with each successive pixel within the active area.

6. An illumination configuration module comprising:

a beam dispersion element operable to receive and spectrally disperse broadband radiation to obtain spectrally dispersed broadband radiation;
the radiation modulation device of any preceding clause being operable to receive the spectrally dispersed broadband radiation on said active area and to selectively spectrally modulate said dispersed broadband radiation to obtain output radiation;
wherein, within the active area, said local pitch is substantially locally dependent on an expected received location of each respective local wavelength of said spectrally dispersed broadband radiation.

7. An illumination configuration module as defined in clause 6, being operable to form at least one beam of said output radiation from only diffracted radiation, having diffracted from said active area, while blocking specularly reflected radiation from said active area.

8. An illumination configuration module as defined in clause 7, wherein the illumination configuration module is operable to form said at least one beam of output radiation from a single diffraction order.

9. An illumination configuration module as defined in clause 7, wherein the illumination configuration module is operable to form a respective said beam of output radiation from each diffraction order of a pair of complementary diffraction orders.

10. An illumination configuration module as defined in clause 9, wherein said illumination configuration module comprises respective beam delivery arrangements being operable to overlap said beams of output radiation an output of the illumination configuration module.

11. An illumination configuration module as defined in clause 7, wherein the illumination configuration module comprises combining optics being operable to combine each diffraction order of a pair of complementary diffraction orders into a single said beam of output radiation.

12. An illumination configuration module as defined in clause 11, wherein said combining optics comprise a half-waveplate in the path of one of said pair of complementary diffraction orders, and a polarized beamsplitter operable to combine the pair of complementary diffraction orders.

13. An illumination configuration module as defined in any of clauses 8 to 12, wherein each said diffraction order comprises a first diffraction order.

14. An illumination configuration module as defined in any of clauses 7 to 13, wherein said local pitch of said active area is such that said diffracted radiation comprises a substantially common diffraction angle per diffraction order for all wavelengths of interest comprised within said spectrally dispersed broadband radiation.

15. An illumination configuration module as defined in any of clauses 7 to 14, wherein said local pitch, said local wavelength and an angle of incidence of said spectrally dispersed broadband radiation are together configured such that one diffraction order of said diffracted radiation is backpropagated along the reverse path as the incident spectrally dispersed broadband radiation for all wavelengths of interest.

16. An illumination configuration module as defined in clause 15, wherein said beam dispersion element is further operable to recombine the backpropagated diffracted radiation.

17. An illumination configuration module as defined in 15 or 16, comprising a common lens arrangement for focusing said spectrally dispersed broadband radiation onto said active area and collecting said backpropagated diffracted radiation.

18. An illumination configuration module as defined in any of clauses 6 to 14, configured such that said spectrally dispersed broadband radiation has a substantially normal incidence on said active area.

19. An illumination configuration module as defined in any of clauses 6 to 18, wherein the beam dispersion element comprises a prism or a grating.

20. A radiation modulation device comprising:

an active area comprising alternating first reflective regions and second reflective regions, said first reflective regions and second reflective regions comprising a configurable displacement between them, in a direction perpendicular to said active area, so as to selectively form a diffractive grating structure for selectively diffracting dispersed radiation incident on said active area;
wherein the active area comprises an adapted reflectivity ratio, describing a reflectivity of the first reflective regions with respect to a reflectivity of second reflective regions, the adapted reflectivity ratio minimizing a difference in reflectivity between the first reflective regions and the second reflective regions.

21. A radiation modulation device as defined in clause 20, wherein said radiation modulation device comprises a grating light valve device; and
said first reflective regions are displaceable regions and said second reflective regions are fixed reflective regions.

22. A radiation modulation device as defined in clause 21, wherein said first reflective regions comprise a different width with respect to the width of the second reflective regions.

23. A radiation modulation device as defined in clause 21 or 22, wherein said first reflective regions comprise a smaller width with respect to the width of the second reflective regions.

24. A radiation modulation device as defined in clause 21, wherein a reflectivity of the second reflective regions is different than a reflectivity of the first reflective regions.

25. A radiation modulation device as defined in clause 21 or 22, wherein a reflectivity of the second reflective regions is less than a reflectivity of the first reflective regions.

26. An illumination configuration module comprising:

a beam dispersion element operable to receive and spectrally disperse broadband radiation to obtain spectrally dispersed broadband radiation;

the radiation modulation device of any of clauses 20 to 25, being operable to receive the spectrally dispersed broadband radiation on said active area and to selectively spectrally modulate said dispersed broadband radiation to obtain output radiation.

27. An illumination configuration module as defined in clause 26, wherein the adapted reflectivity ratio is constant across the active area.

28. An illumination configuration module as defined in clause 26, configured such that a local adapted reflectivity ratio substantially depends on a local wavelength of said spectrally dispersed broadband radiation incident on said active area.

29. An illumination configuration module as defined in clause 26, wherein a local adapted reflectivity ratio substantially varies continuously over said active area.

30. An illumination configuration module as defined in clause 26, wherein the adapted reflectivity ratio is configured locally for each wavelength of interest comprised within said spectrally dispersed broadband radiation.

31. An illumination configuration module as defined in any of clauses 6 to 19 and 26 to 30,

further comprising a broadband radiation source operable to provide said broadband radiation.

32. A metrology device comprising a radiation modulation device according to any one of the claims 1 to 5 and 20 to 25, or an illumination configuration module as claimed in any of claims 6 to 19 and 26 to 30, operable to use said output illumination beam as measurement illumination for a measurement.

33. A metrology device as defined in clause 32, wherein the metrology device comprises a scatterometer, interferometer or holographic microscope.

34. A metrology device as defined in clause 32 or 33, wherein the metrology device comprises an alignment sensor or level sensor.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

**Claims**

1. A radiation modulation device comprising:

    an active area comprising alternating first reflective regions and second reflective regions, said first reflective regions and second reflective regions comprising a configurable displacement between them, in a direction perpendicular to said active area, so as to selectively form a diffractive grating structure for selectively diffracting dispersed radiation incident on said active area;
    wherein a local pitch of said active area, the local pitch being defined by a combined width of one of said first reflective regions and an adjacent one of said second reflective regions, varies within said active area.

2. A radiation modulation device as claimed in claim 1, comprising a grating light valve device having a plurality of reflective ribbons, wherein each of said first reflective regions and second reflective regions comprises a respective reflective ribbon of said plurality of reflective ribbons.

3. A radiation modulation device as claimed in any of claims 1 to 2, wherein said active are comprises an array of pixels, and said local pitch monotonically varies with each successive pixel within the active area.

4. An illumination configuration module comprising:

    a beam dispersion element operable to receive and spectrally disperse broadband radiation to obtain spectrally dispersed broadband radiation;
the radiation modulation device of any preceding claim being operable to receive the spectrally dispersed broadband radiation on said active area and to selectively spectrally modulate said dispersed broadband radiation to obtain output radiation;
wherein, within the active area, said local pitch is substantially locally dependent on an expected received location of each respective local wavelength of said spectrally dispersed broadband radiation.

5. An illumination configuration module as claimed in claim 4, being operable to form at least one beam of said output radiation from only diffracted radiation, having diffracted from said active area, while blocking specularly reflected radiation from said active area.

6. An illumination configuration module as claimed in claim 5, wherein the illumination configuration module is operable to form said at least one beam of output radiation from a single diffraction order.

7. An illumination configuration module as claimed in claim 5, wherein the illumination configuration module is operable to form a respective said beam of output radiation from each diffraction order of a pair of complementary diffraction orders.

8. An illumination configuration module as claimed in claim 7, wherein said illumination configuration module comprises respective beam delivery arrangements being operable to overlap said beams of output radiation an output of the illumination configuration module.

9. An illumination configuration module as claimed in claim 5, wherein the illumination configuration module comprises combining optics being operable to combine each diffraction order of a pair of complementary diffraction orders into a single said beam of output radiation.

10. An illumination configuration module as claimed in claim 9, wherein said combining optics comprise a half-waveplate in the path of one of said pair of complementary diffraction orders, and a polarized beamsplitter operable to combine the pair of complementary diffraction orders.

11. An illumination configuration module as claimed in any of claims 5 to 10, wherein said local pitch of said active area is such that said diffracted radiation comprises a substantially common diffraction angle per diffraction order for all wavelengths of interest comprised within said spectrally dispersed broadband radiation.

12. An illumination configuration module as claimed in any of claims 5 to 11, wherein said local pitch, said local wavelength and an angle of incidence of said spectrally dispersed broadband radiation are together configured such that one diffraction order of said diffracted radiation is backpropagated along the reverse path as the incident spectrally dispersed broadband radiation for all wavelengths of interest.

13. An illumination configuration module as claimed in claim 12, wherein said beam dispersion element is further operable to recombine the backpropagated diffracted radiation.

14. An illumination configuration module as claimed in 12 or 13, comprising a common lens arrangement for focusing said spectrally dispersed broadband radiation onto said active area and collecting said backpropagated diffracted radiation.

15. A metrology device comprising a radiation modulation device according to any one of the claims 1 to 3, or an illumination configuration module as claimed in any of claims 4 to 14, operable to use said output illumination beam as measurement illumination for a measurement.

**Fig. 1**

**Fig. 2**

**Fig. 3**

**Fig. 4**

Fig. 5

**Fig. 6**

**Fig. 7**

**Fig. 8**

**Fig. 9**

(a)

(b)

Fig. 10

1155 1150 1140 1145 1135 1130
1105 1120 1125
1100 1110 1115
1103 1160
1175 1165
1170
1180
1185

X
Y Z

**Fig. 11**

1203 1140 1145 1135 1130
1213 1240
1155 1150 1120 1125
1105 1110 1115
1100 1203
1103 1160
1209 1165
1175
1170
1206

X
Y Z

**Fig. 12**

**Fig. 13**

**Fig. 14**

**Fig. 15**

Europäisches
Patentamt

European
Patent Office

Office européen
des brevets

## EUROPEAN SEARCH REPORT

Application Number

EP 23 16 1366

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br><br>Y<br>A | US 6 934 070 B1 (MAHESHWARI DINESH [US] ET AL) 23 August 2005 (2005-08-23)<br>* abstract; figures *<br>* column 1, lines 25-52 *<br>* column 10, line 36 – column 11, line 34 * | 1-11<br><br>15<br>12-14 | INV.<br>G02B5/18<br>G02B26/08 |
| X<br><br>Y<br>A | US 6 983 087 B1 (MAHESHWARI DINESH [US]) 3 January 2006 (2006-01-03)<br>* abstract *<br>* column 11, lines 22-37; figure 8B * | 1-3<br><br>15<br>12-14 | |
| Y | WO 2021/259645 A1 (ASML HOLDING NV [NL]) 30 December 2021 (2021-12-30)<br>* abstract *<br>* paragraph [0128]; figure 6A * | 15 | |
| A | "ILLUMINATION MODULE AND ASSOCIATED METHODS AND METROLOGY APPARATUS", RESEARCH DISCLOSURE, KENNETH MASON PUBLICATIONS, HAMPSHIRE, UK, GB<br>,<br>vol. 698, no. 79<br>23 May 2022 (2022-05-23), XP007150344, ISSN: 0374-4353<br>Retrieved from the Internet:<br>URL:https://www.researchdisclosure.com/database/RD698079<br>[retrieved on 2022-05-23]<br>* paragraph [0001]; figures 5-7 * | 1-15 | TECHNICAL FIELDS SEARCHED (IPC)<br><br>G02B |

The present search report has been drawn up for all claims

| Place of search | Date of completion of the search | Examiner |
|---|---|---|
| Munich | 29 August 2023 | Riblet, Philippe |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 16 1366

This annex lists the patent family members relating to the patent documents cited in the above-mentioned European search report.
The members are as contained in the European Patent Office EDP file on
The European Patent Office is in no way liable for these particulars which are merely given for the purpose of information.

29-08-2023

| Patent document cited in search report | | Publication date | Patent family member(s) | | Publication date |
|---|---|---|---|---|---|
| US 6934070 | B1 | 23-08-2005 | NONE | | |
| US 6983087 | B1 | 03-01-2006 | NONE | | |
| WO 2021259645 | A1 | 30-12-2021 | CN | 115702391 A | 14-02-2023 |
| | | | JP | 2023530864 A | 20-07-2023 |
| | | | TW | 202217480 A | 01-05-2022 |
| | | | US | 2023266681 A1 | 24-08-2023 |
| | | | WO | 2021259645 A1 | 30-12-2021 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6952253 B
- US 20100328655 A
- US 2011102753 A1
- US 20120044470 A
- US 20110249244 A
- US 20110026032 A
- EP 1628164 A
- US 451599
- US 11708678 B
- US 12256780 B
- US 12486449 B
- US 12920968 B
- US 12922587 B
- US 13000229 B
- US 13033135 B
- US 13533110 B
- US 13891410 B
- WO 2011012624 A
- US 20160161863 A
- US 20160370717 A1
- US 7265364 B
- US 7646471 B
- US 2010233600 A1
- WO 2016102127 A1
- US 6961116 B
- US 2015261097 A1
- US 6947613 B